# EUROPÄISCHE PATENTSCHRIFT

(11) **EP 2 519 985 B1**
(45) Veröffentlichungstag und Bekanntmachung des Hinweises auf die Patenterteilung: **02.05.2018**
(21) Anmeldenummer: 11711853.9
(22) Anmeldetag: 28.03.2011
(51) Int. Cl.: H01L 33/48, H01L 33/50, H01L 33/56, H01L 33/54, G02B 6/00, H01L 33/60

(54) **OPTOELEKTRONISCHES BAUELEMENT UND VERFAHREN ZUM HERSTELLEN EINES OPTOELEKTRONISCHEN BAUELEMENTS**
OPTOELECTRONIC COMPONENT AND METHOD FOR PRODUCING AN OPTOELECTRONIC COMPONENT
COMPOSANT OPTOÉLECTRONIQUE ET PROCÉDÉ DE FABRICATION D'UN COMPOSANT OPTOÉLECTRONIQUE

(30) Priorität: 27.04.2010 DE 102010028246
(43) Veröffentlichungstag der Anmeldung: 07.11.2012
(73) Patentinhaber: Osram Opto Semiconductors Gmbh, 93055 Regensburg (DE)
(72) Erfinder: ILLEK, Stefan, 93093 Donaustauf (DE); LINKOV, Alexander, 93059 Regensburg (DE); SABATHIL, Matthias, 93059 Regensburg (DE)
(74) Vertreter: Epping - Hermann - Fischer
(86) Internationale Anmeldenummer: PCT/EP2011/054680
(87) Internationale Veröffentlichungsnummer: WO 2011/134727

(56) Entgegenhaltungen:
- WO-A1-2009/135620
- DE-A1-102007 007 847
- DE-A1-102008 022 888
- DE-U1- 20 321 614
- JP-A- 2010 003 941
- US-A- 5 813 753
- US-A1- 2008 315 228

## Beschreibung

Die vorliegende Erfindung betrifft ein optoelektronisches Bauelement mit einem Halbleiterchip zum Emittieren von elektromagnetischer Strahlung, sowie eine Leuchtvorrichtung mit mindestens einem solchen optoelektronischen Bauelement. Darüber hinaus ist ein Verfahren zum Herstellen eines optoelektronischen Bauelements angegeben.

Aus dem Stand der Technik sind optoelektronische Bauelemente und diese aufweisende Leuchtvorrichtungen bekannt. So offenbart die Druckschrift WO2009/135620A1 eine Leuchtvorrichtung mit Leuchtmittel, die elektromagnetische Strahlung emittieren. Eine Ausgestaltung eines Leuchtmittels kann ein optoelektronisches Bauelement sein. Durch Wechselwirkung mit Partikeln wird die elektromagnetische Strahlung zum Teil ausgelenkt und zum Teil bezüglich ihrer Wellenlänge verändert. Das Auslenken der elektromagnetischen Strahlung kann durch einen Gradienten der Partikeldichte erreicht. Die Einstellung eines Gradienten der Partikeldichte ist jedoch in der Herstellung sehr aufwändig, schwer reproduzierbar und teuer.

Die optoelektronischen Bauelemente weisen eine optisch aktive Epitaxie-Schicht auf, die auf einem Träger aufgebracht ist, wie beispielsweise in der Druckschrift DE102005003460A1 offenbart.

Aufgabe der Erfindung ist es, ein optoelektronisches Bauelement sowie eine Leuchtvorrichtung mit mindestens einem solchen optoelektronischen Bauelement anzugeben, das Partikel in einem Medium aufweist, so dass die elektromagnetische Strahlung in eine Vorzugsrichtung, nämlich horizontal zum Träger, ausgelenkt wird. Zudem soll eine gleichmäßige Lichtverteilung in der Leuchtvorrichtung ohne aufwändige Auskoppelstrukturen möglich sein.

Diese Aufgabe wird gelöst durch:
- ein optoelektronisches Bauelement gemäß Patentanspruch 1,
- ein Verfahren zur Herstellung eines optoelektronischen Bauelements gemäß Patentanspruch 15 bzw. durch
- eine Leuchtvorrichtung gemäß Patentanspruch 13.

Weiterbildungen und vorteilhafte Ausgestaltungen des optoelektronischen Bauelements bzw. der Leuchtvorrichtung sind in den abhängigen Ansprüchen angegeben.

### Beispielhafte Ausführungsformen

Verschiedene Ausführungsformen weisen ein optoelektronisches Bauelement mit einem Träger und mit mindestens einem Halbleiterchip auf. Der Halbleiterchip ist auf dem Träger angeordnet und emittiert eine Primärstrahlung. Ferner weist das Bauelement ein den Halbleiterchip zumindest teilweise umschließendes und zumindest teilweise transparentes Medium auf. Das Medium hat eine Höhe über dem Träger und eine Breite entlang des Trägers. In das Medium sind Partikel zur Wechselwirkung mit der Primärstrahlung eingebracht. Das Medium weist ein Verhältnis der Höhe zu der Breite (Aspektverhältnis) von größer als 1 auf. Dadurch wird gewährleistet, dass elektromagnetische Strahlung in eine Vorzugsrichtung, nämlich horizontal zum Träger, ausgelenkt wird.

Der Halbleiterchip weist üblicherweise eine aktive Zone auf, die die Primärstrahlung emittiert. Die aktive Zone kann ein pn-Übergang, eine Doppelheterostruktur, Mehrfach-Quantentopfstruktur (MQW) oder Einfach-Quantentopfstruktur (SQW) sein. Quantentopfstruktur bedeutet: Quantentöpfe (3-dim), Quantendrähte (2-dim) und Quantenpunkte (1-dim).

Das Medium kann beispielsweise ein Silikon, Epoxy, Glas oder Keramik aufweisen. Das Medium sollte möglichst lichtbeständig und für die Primärstrahlung zumindest teilweise transparent sein.
Das optoelektronische Bauelement soll elektromagnetische Strahlung in eine Vorzugsrichtung, nämlich horizontal zum Träger, auslenken. Zudem soll eine gleichmäßige Lichtverteilung in der Leuchtvorrichtung ohne aufwändige Auskoppelstrukturen möglich sein. Dies wird dadurch erreicht, dass das Medium mit den Partikeln ein Aspektverhältnis von größer als 1 aufweist. Diese horizontale Auslenkung der elektromagnetischen Strahlung ist beispielsweise für die Einkopplung der elektromagnetischen Strahlung in einen Lichtleiter besonders vorteilhaft.
Der Kerngedanke der Erfindung ist es, ein streuendes Medium anzuordnen, das auf einfache und effiziente Weise das frontal emittierte Licht eines LED-Chips lateral umlenkt. Damit kann die Anwendung in einem flächigen Lichtleiter vereinfacht bzw. erst ermöglicht werden. Für eine optimale Effizienz und Seitenemission müssen die Konzentration der Partikel und das Aspektverhältnis aufeinander abgestimmt werden.

In der erfindungsgemäßen Ausführungsform des optoelektronischen Bauelements sind die Partikel homogen in dem Medium verteilt. Dies ist vorteilhaft, da eine homogene Verteilung besonders einfach herstellbar ist und eine gleichmäßige Abstrahlung von elektromagnetischer Strahlung ermöglicht.

In der erfindungsgemäßen Ausführungsform des optoelektronischen Bauelements weisen die Partikel Leuchtstoffpartikel auf, die für eine Absorption der Primärstrahlung und eine Emission eines ersten Anteils einer Sekundärstrahlung ausgelegt sind. Die Leuchtstoffpartikel können aus einem phosphoreszenten Material bestehen. Als phosphoreszentes Material können In einem bevorzugten Ausführungsbeispiel wird ein Ytrium-Aluminium-Granat in einer Konzentration von 5 bis 15 Gewichtsprozent benutzt, das blaues Primärlicht in gelbes Licht umsetzt. Bei einer Konzentration von 5 Gewichtsprozent des Ytrium-Aluminium-Granats in dem Medium ergibt sich eine bläulich weiße Sekundärstrahlung. Bei der höheren Konzentration von 15 Gewichtsprozent ergibt sich eine gelblich weiße Sekundärstrahlung.

In der erfindungsgemäßen Ausführungsform des optoelektronischen Bauelements weisen die Partikel Streupartikel auf, die für die Streuung der Primärstrahlung ausgelegt sind und dabei einen zweiten Anteil zur Sekundärstrahlung beitragen. Bei der Wechselwirkung von elektromagnetischer Strahlung und Streupartikel wird die Wellenlänge der elektromagnetischen Strahlung nicht verändert. Die Begriffe Streupartikel und Reflexionspartikel werden in der vorliegenden Anmeldung synonym verwendet.
In einer bevorzugten Ausführungsform weisen die Streupartikel Bariumsulfid und/oder Bariumsulfit und/oder Bariumsulfat und/oder Titandioxid auf. Eine mittlere Größe der Titandioxid-Streupartikel beträgt etwa 300 nm. Die Konzentration der Streupartikel liegt zwischen 2 und 10 Gewichtsprozent. Bei einer Konzentration größer 5 Gewichtsprozent ist die Intensität der senkrecht emittierten Komponente der Sekundärstrahlung nahe Null.
Für den Fall, dass Sekundärstrahlung erzeugt wird, sorgt das Medium mit den Streupartikeln für eine gute Mischung von blauem und gelbem Licht und für eine geeignete Auslenkung der Primärstrahlung.
In einer bevorzugten Ausführungsform beträgt die Höhe des Mediums zwischen dem 1-fachen und dem 3-fachen der Chipbreite des Halbleiterchips entlang des Trägers. Dies ist vorteilhaft, da bei obigen Abmessungen besonders viel Sekundärstrahlung seitlich aus dem optoelektronischen Bauelement auskoppelbar ist.
In einer bevorzugten Ausführungsform ist eine reflektierende Schicht vorgesehen, die sich zumindest bereichsweise an einer dem Halbleiterchip zugewandten Seite des Mediums erstreckt. Dies ist vorteilhaft, da dadurch verhindert wird, dass die von den Streupartikeln reflektierte und die von den Leuchtstoffpartikeln emittierte Sekundärstrahlung durch Absorption am Träger verloren geht.

In der erfindungsgemäßen Ausführungsform ist eine teilreflektierende Schicht vorgesehen, die zumindest bereichsweise an einer vom Halbleiterchip abgewandten Seite des Mediums angeordnet ist. Die teilreflektierende Schicht reflektiert einen Teil der elektromagnetischen Strahlung in das Medium zurück. Dabei reflektiert die teilreflektierende Schicht nicht Wellenlängen selektiv. Diese Schicht verhindert, dass Teile der Sekundärstrahlung die vom Halbleiterchip abgewandte Seite des Mediums verlassen. Der Anteil der von der Schicht in das Medium zurückreflektierten Sekundärstrahlung kann über den Gehalt an Titandioxid-Reflexionspartikeln in der Schicht eingestellt werden.
In einer bevorzugten Ausführungsform ist die teilreflektierende Schicht an der vom Halbleiterchip abgewandten Seite des Mediums in unmittelbarem Kontakt mit dem Medium angeordnet. Dies ist vorteilhaft, da die Herstellung einfach ist.
In einer bevorzugten Ausführungsform weist die reflektierende Schicht an der dem Halbleiterchip zugewandten Seite des Mediums und/oder die teilreflektierende Schicht an der vom Halbleiterchip abgewandten Seite des Mediums Silikon auf, das Titandioxid-Partikel aufweist.

In einer bevorzugten Ausführungsform ist das optoelektronische Bauelement an einen Lichtleiter optisch gekoppelt.
In einer bevorzugten Ausführungsform ist zwischen dem optoelektronischen Bauelement und dem Lichtleiter ein Luftspalt vorgesehen, der zu einer besseren Einkopplung in die geführten Moden des Lichtleiters führt.

In der erfindungsgemäßen Ausführungsform des Verfahrens zur Herstellung eines optoelektronischen Bauelements wird ein Halbleiterchip auf einem Träger bereitgestellt. Es werden Partikel in ein Medium aus einem transparenten Matrixmaterial, insbesondere einem transparenten Silikon, eingebracht. Anschließend wird das Medium in eine Form gegossen. Danach erfolgt das thermische Aushärten des Mediums. Danach wird das Medium auf den Halbleiterchip derart aufgebracht, dass ein Aspektverhältnis von größer als 1 erreicht wird.
Ein alternatives Verfahren zur Herstellung eines optoelektronischen Bauelements kann wie folgt angegeben werden. Das Medium wird mit den Partikeln im Verbund durch ein Formpressen (*compression molding*) gleichzeitig auf den Halbleiterchip aufgebracht. Dabei wird eine Form aufgelegt und diese unter Druck ausgespritzt. Anschließend wird das Medium ausgehärtet. Die durch die alternativen Verfahren hergestellten optoelektronischen Bauelemente können abschließend an einen Lichtwellenleiter optisch gekoppelt werden.
Die gemäß obigen Verfahren hergestellte optoelektronische Bauelement ist kostengünstig in der Herstellung und erreicht hohe optische Effizienzen. Mit einer geeigneten lateralen Anordnung dieser optoelektronischen Bauelemente lässt sich auf einfache Weise eine Flächenlichtquelle erzeugen. Es kann eine homogene Leuchtdichte bei gleichzeitig begrenzter Anzahl von optoelektronischen Bauelementen erreicht werden. Es ergibt sich eine effiziente, randlose und selbstkühlende Flächenlichtquelle. Die Flächenlichtquelle kann sehr dünn gefertigt werden und flexibel sein.

### KURZE BESCHREIBUNG DER ZEICHNUNGEN

Verschiedene Ausführungsbeispiele zum Verständnis der erfindungsgemäßen Lösung werden im Folgenden anhand der Zeichnungen näher erläutert.
Figur 1 zeigt in einer Schnittansicht ein nicht erfindungsgemäßes Ausführungsbeispiel eines optoelektronischen Bauelements;
Figur 2 zeigt in einer Schnittansicht ein nicht erfindungsgemäßes Ausführungsbeispiel eines optoelektronischen Bauelements;
Figur 3 zeigt die Abstrahlcharakteristik eines optoelektronischen Bauelements für verschiedene Aspektverhältnisse;
Figur 4 zeigt eine Abstrahlcharakteristik eines optoelektronischen Bauelements als Funktion des Winkels;
Figur 5 zeigt in einer Schnittansicht ein erfindungsgemäßes Ausführungsbeispiel eines optoelektronischen Bauelements;
Figur 6a zeigt in einer Schnittansicht ein nicht erfindungsgemäßes Ausführungsbeispiel eines optoelektronischen Bauelements;
Figur 6b zeigt in einer Schnittansicht ein nicht erfindungsgemäßes Ausführungsbeispiel eines optoelektronischen Bauelements;
Figur 7 zeigt in einer Schnittansicht ein nicht erfindungsgemäßes Ausführungsbeispiel einer Leuchtvorrichtung mit zwei optoelektronischen Bauelementen;
Figur 7a zeigt eines der beiden optoelektronischen Bauelemente aus Figur 7;
Figur 7b zeigt die Simulation der Leuchtdichteverteilung um das optoelektronische Bauelement gemäß Figur 7a;
Figur 8 zeigt in einer Schnittansicht ein nicht erfindungsgemäßes Ausführungsbeispiel einer Leuchtvorrichtung mit zwei optoelektronischen Bauelementen;
Figur 8a zeigt eines der beiden optoelektronischen Bauelemente aus Figur 8;
Figur 8b zeigt die Simulation der Leuchtdichteverteilung um das optoelektronische Bauelement gemäß Figur 8a;
Figur 9 zeigt in einer Draufsicht ein Ausführungsbeispiel einer Leuchtvorrichtung mit mehreren optoelektronischen Bauelementen;
Figur 10 zeigt in einer Schnittansicht ein nicht erfindungsgemäßes Ausführungsbeispiel einer Leuchtvorrichtung mit zwei optoelektronischen Bauelementen;
Figur 10a zeigt eines der beiden optoelektronischen Bauelemente aus Figur 10;
Figur 10b zeigt die Simulation der Leuchtdichteverteilung um das optoelektronisches Bauelement gemäß Figur 10a;
Figur 11 zeigt in einer Schnittansicht ein erfindungsgemäßes Ausführungsbeispiel einer Leuchtvorrichtung mit zwei optoelektronischen Bauelementen;
Figur 11a zeigt eines der beiden optoelektronischen Bauelemente aus Figur 11;
Figur 11b zeigt die Simulation der Leuchtdichteverteilung um das optoelektronische Bauelement gemäß Figur 11a;
Figur 12 zeigt in einer Schnittansicht ein erfindungsgemäßes Ausführungsbeispiel einer Leuchtvorrichtung mit optoelektronischen Bauelementen;
Figur 12a zeigt eines der beiden optoelektronischen Bauelemente aus Figur 12 und
Figur 12b zeigt die Simulation der Leuchtdichteverteilung um das optoelektronische Bauelement gemäß Figur 12a.

### AUSFÜHRUNGSBEISPIELE

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und zum besseren Verständnis übertrieben groß dargestellt sein.

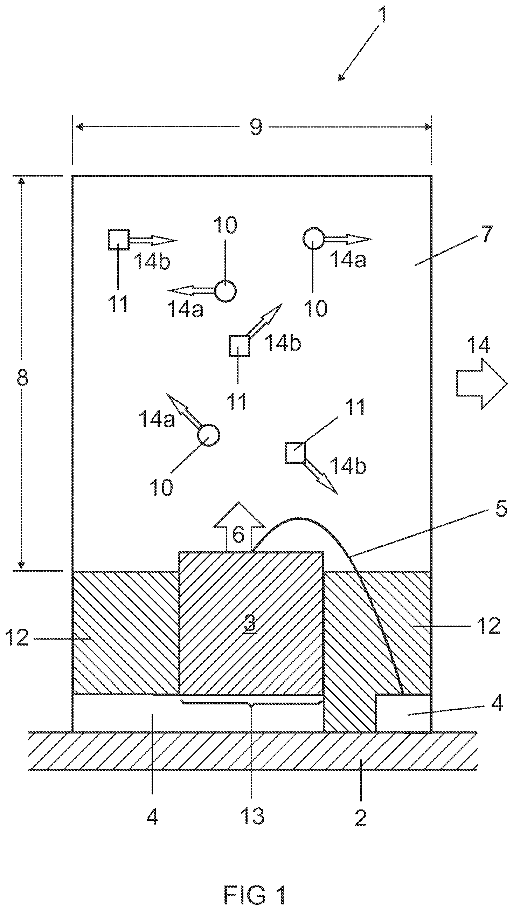

Figur 1 zeigt ein optoelektronisches Bauelement 1. Auf einem Träger 2 ist ein Halbleiterchip 3 aufgebracht. Die elektrische Kontaktierung erfolgt über Kontakte 4 und einen Bonddraht 5. Der Halbleiterchip 3 emittiert eine Primärstrahlung 6. Der Halbleiterchip 3 ist zumindest teilweise umschlossen von einem zumindest teilweise transparentem Medium 7 mit einer Höhe 8 über dem Träger 2 und einer Breite 9 entlang des Trägers 2 (Aspektverhältnis). In dem Medium 7 sind Partikel 10, 11 eingebracht die mit der Primärstrahlung 6 wechselwirken. Das Medium 7 weist ein Aspektverhältnis von größer als 1 auf. Die Partikel 10, 11 sind homogen in dem Medium 7 verteilt. Die Partikel 10, 11 weisen Leuchtstoffpartikel 10 auf, die für eine Absorption der Primärstrahlung 6 und eine Emission eines ersten Anteils 14a einer Sekundärstrahlung 14 ausgelegt sind. Die Leuchtstoffpartikel 10 weisen insbesondere ein phosphoreszentes Material auf, wie Ytrium-Aluminium-Granat. Die Leuchtstoffpartikel liegen in einer Konzentration von 5 bis 15 Gewichtsprozent vor. Die Partikel 10,11 weisen Streupartikel 11 auf, die für die Streuung der Primärstrahlung ausgelegt sind und dabei einen zweiten Anteil 14b zur Sekundärstrahlung 14 beitragen. Streupartikel 11 verändern bei der Wechselwirkung mit elektromagnetischer Strahlung nicht die Wellenlänge der elektromagnetischen Strahlung. Zum Begriff Streupartikel 11 synonym ist der Begriff Reflexionspartikel. Die Streupartikel 11 weisen Bariumsulfid und/oder Bariumsulfit und/oder Bariumsulfat und/oder Titandioxid auf. Die Streupartikel liegen in einer Konzentration von 2 bis 10 Gewichtsprozent vor. Die Höhe 8 des Mediums 7 beträgt zwischen dem etwa 1-fachen und etwa 3-fachen der Chipbreite 13 des Halbleiterchips 3 entlang des Trägers 2. Mit der Höhe 8 des Mediums 7 ist der Anteil der lateralen Emission der Sekundärstrahlung einstellbar. Beispielsweise ist für einen Halbleiterchip 3 mit einer Chipbreite 13 von 300 µm eine Höhe 8 des Mediums 7 von 300 µm bis 900 µm vorteilhaft. Eine reflektierende Schicht 12 ist zumindest bereichsweise an einer dem Halbleiterchip 3 zugewandten Seite des Mediums 7 vorgesehen. Die Geometrie des Bauelements ist derart ausgelegt, dass die Seitenflächen des Mediums 7, die senkrecht auf den Träger stehen, die Oberfläche des Mediums, die parallel zum Träger angeordnet ist, bezüglich Ihres Flächeninhalts dominieren.

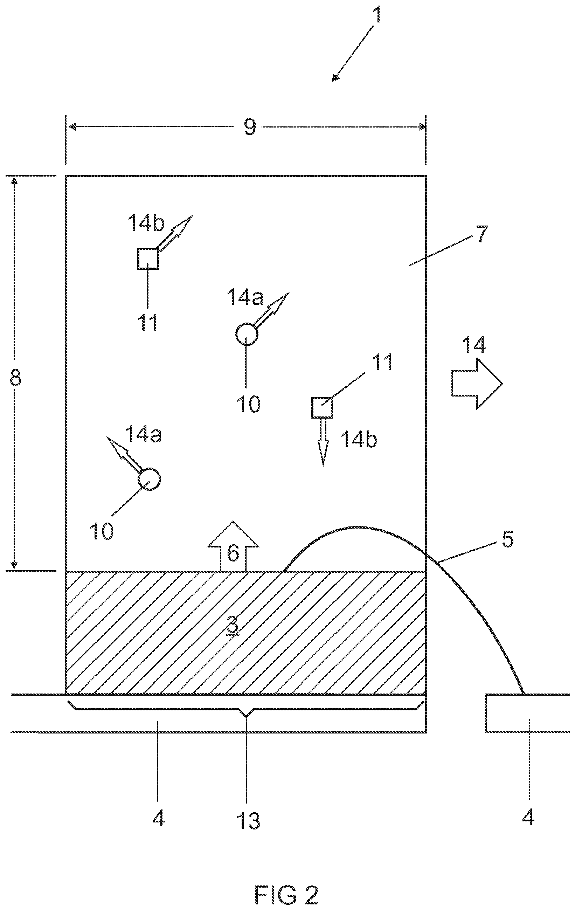

Figur 2 zeigt ein optoelektronisches Bauelement 1, bei dem die Breite 9 des Mediums in etwa der Breite 13 des Halbleiterchips 3 entspricht. Die Notwendigkeit einer reflektierenden Schicht auf der dem Halbleiterchip 3 zugewandten Seite des Mediums 7 entfällt. Die übrigen Komponenten entsprechen denen aus Figur 1.

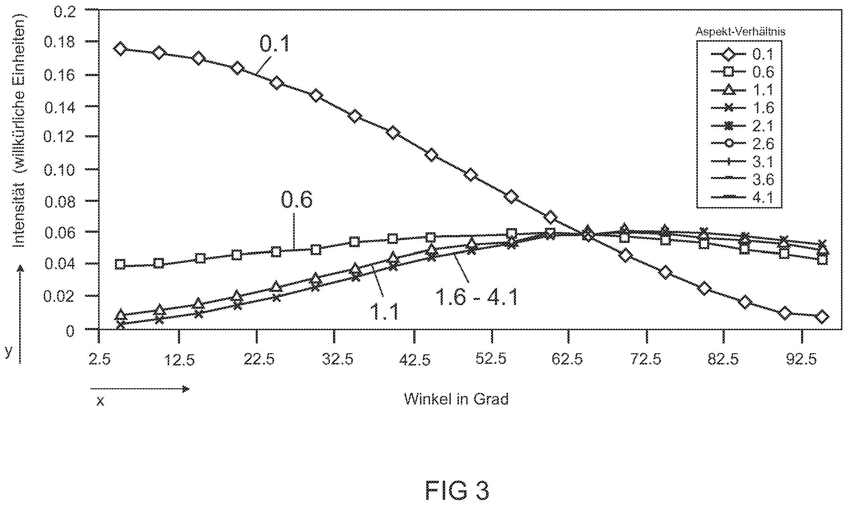

Figur 3 zeigt die berechnete Abstrahlcharakteristik für verschiedene Aspektverhältnisse für ein mit Leuchtstoffpartikeln 10 gefülltes Medium 7. Das Medium 7 ist vorliegend eine Silikon-Schicht, die Leuchtstoffpartikel 10 sind vorliegend phosphoreszente Materialien. Die Abstrahlcharakteristik wird für unterschiedliche Werte des Aspektsverhältnisse zwischen 0.1 und 4.1 dargestellt. Auf der Abszisse x wird der Abstrahlwinkel und auf der Ordinate y die Intensität der Sekundärstrahlung 14 aufgetragen. Bei einem Aspektverhältnis von 0.1 ist die vom optoelektronischen Bauelement abgestrahlte Intensität bei kleinen Winkeln maximal. Für Aspektverhältnisse von 1.1 und höher fällt die abgestrahlte Intensität bei kleinen Winkeln auf verschwindende Werte. Die Intensität der Sekundärstrahlung 14 erreicht maximale Werte im Winkelbereich zwischen 60 und 90 Grad. Mit anderen Worten ist die laterale Abstrahlung stark begünstigt. Die Winkelverteilung kann neben dem Aspektverhältnis auch durch die Partikelkonzentration beeinflusst werden.

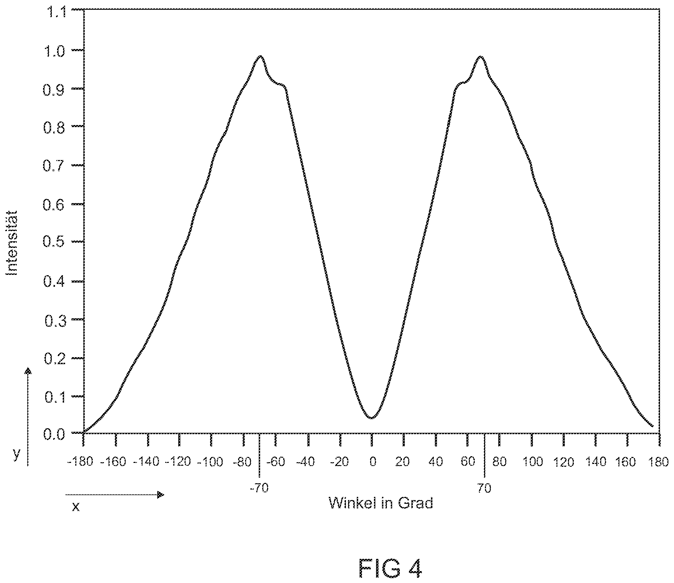

Figur 4 zeigt eine typische Abstrahlcharakteristik eines optoelektronischen Bauelements 1 als Funktion des Winkels. Auf der x-Achse sind Winkel zwischen -180 Grad und +180 Grad aufgetragen. Der Winkel von 0 Grad entspricht der Normalen auf die vom Halbleiterchip 3 abgewandte Seite des Mediums 7. Die Intensitätsmaxima liegen bei einem Winkel von etwa -70 Grad und von etwa +70 Grad. Bei einem Winkel von 0 Grad verschwindet die Intensität nahezu.

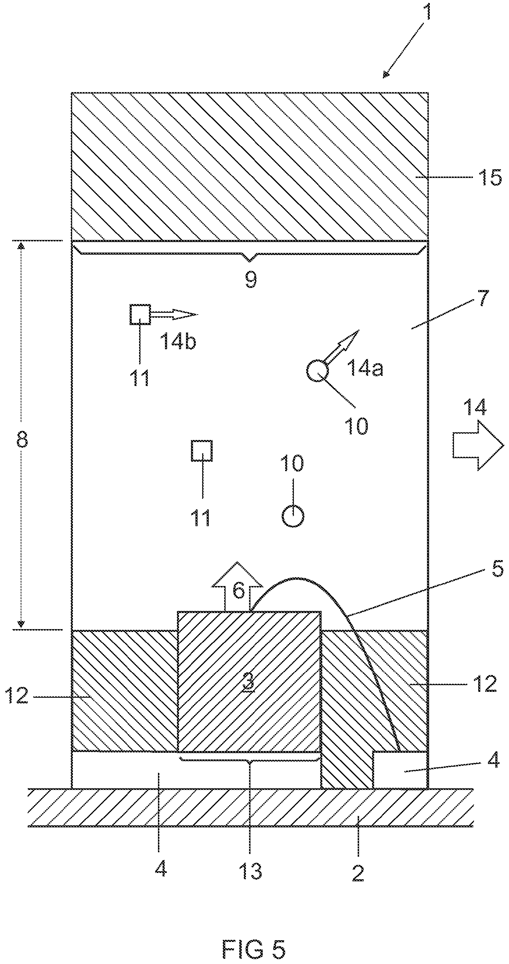

Figur 5 zeigt ein optoelektronisches Bauelement mit einer teilreflektierenden Schicht 15, die zumindest bereichsweise an einer vom Halbleiterchip 3 abgewandten Seite des Mediums 7 vorgesehen ist. Die teilreflektierende Schicht 15 ist an der vom Halbleiterchip 3 abgewandten Seite des Mediums 7 in unmittelbarem Kontakt mit dem Medium 7 angeordnet. Die teilreflektierende Schicht 15 kann ein Silikon sein, das mit Titandioxidpartikeln gefüllt ist. Die teilreflektierende Schicht 15 reflektiert Sekundärstrahlung aus dem gesamten sichtbaren Spektralbereich. Insbesondere erfolgt keine Wellenlängen abhängige Reflektion. Mit anderen Worten erfolgt keine Filterung der Sekundärstrahlung bezüglich der Wellenlänge. Die teilreflektierende Schicht 15 dient zum Einstellen der Balance zwischen Frontalemission und Seitenemission. Je nach Konzentration der Titandioxidpartikel, wird der erste und der zweite Anteil 14a und 14b der Sekundärstrahlung 14 mehr oder weniger stark reflektiert. In einem Grenzfall kann die senkrechte - also normal auf die dem Halbleiterchip 3 gegenüberliegende Seite des Mediums 7 - Emission von Sekundärstrahlung 14 vollständig verhindert werden. Mit anderen Worten wird die frontale Emission zugunsten der seitlichen Emission unterdrückt. Durch die teilreflektierende, weiße Schicht 15 wird der durch die Leuchtstoffpartikel hervorgerufene, unerwünschte, gelbliche Farbeindruck vermieden. Die übrigen Komponenten entsprechen denen in Figur 1.

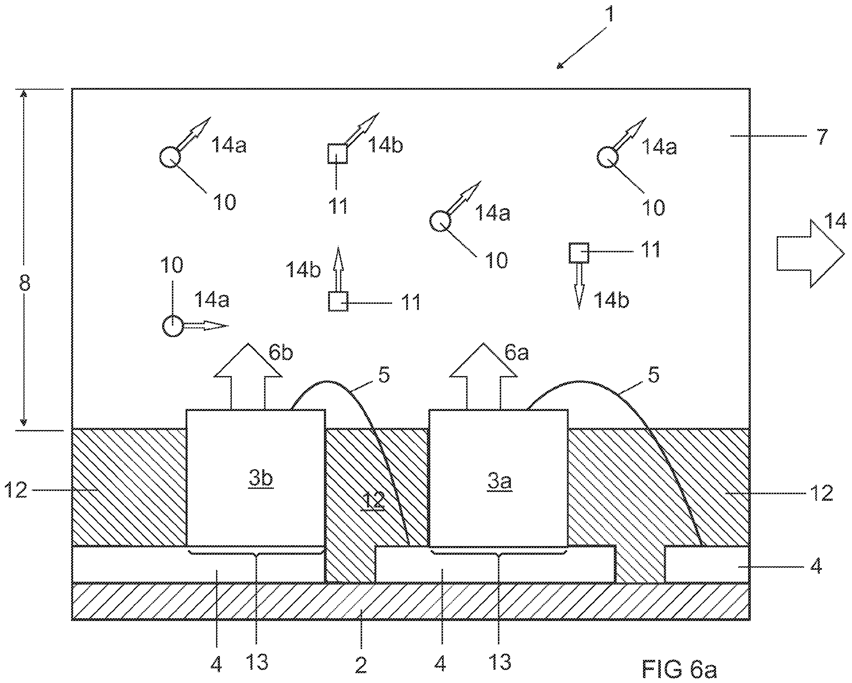

Figur 6a zeigt zwei Halbleiterchips 3a und 3b innerhalb eines optoelektronischen Bauelements 1. Wiederum beträgt die Höhe 8 des Mediums 7 zwischen dem 1-fachen und 3-fachen der Chipbreite 13. Das Medium enthält im vorliegenden nicht erfindungsgemäßen Ausführungsbeispiel sowohl Leuchtstoffpartikel 10 als auch Streupartikel 11. Die Streupartikel 11 bewirken ein Mischen der Primärstrahlung 6a und 6b mit dem ersten Anteil 14a der Sekundärstrahlung. Die Primärstrahlung 6a ist die von einem ersten Halbleiterchip 3a emittierte elektromagnetische Strahlung einer ersten Wellenlänge. Die Primärstrahlung 6b ist die von einem zweiten Halbleiterchip 3b emittierte elektromagnetische Strahlung einer zweiten Wellenlänge. Der erste Anteil 14a der Sekundärstrahlung ist durch Leuchtstoffpartikel 10 konvertiertes Licht. Darüber hinaus sorgen die Streupartikel 11 für die gewünschte, nämliche seitliche, Abstrahlcharakteristik. Die übrigen Komponenten entsprechen denen in Figur 1.

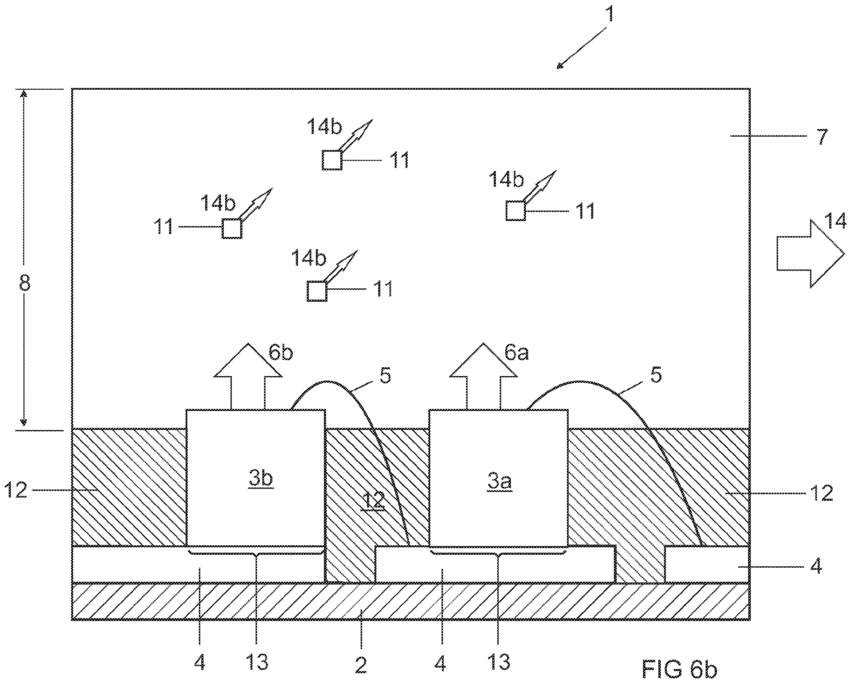

Figur 6b zeigt wie schon Figur 6a zwei Halbleiterchips 3a und 3b innerhalb eines optoelektronischen Bauelements 1. Im Gegensatz zu Figur 6a sind im Medium 7 ausschließlich Streupartikel 11 eingebracht. Eine Wellenlängenkonversion findet ohne Leuchtstoffpartikel 10 nicht statt. Im Medium 7 findet also nur eine Farbmischung und ein seitliches Auslenken der Primärstrahlung 6 statt. Das gewünschte Spektrum wird durch die verschiedenen Wellenlängen des ersten Anteils 6a der Primärstrahlung und des zweiten Anteils 6b der Primärstrahlung erreicht. Die übrigen Komponenten entsprechen denen in Figur 1. In einem nicht gezeigten Ausführungsbeispiel ist ein optoelektronisches Bauelement vorgesehen mit mindestens drei Halbleiterchips, die im roten, grünen und blauen Spektralbereich emittieren. Eine Wellenlängenkonversion durch Leuchtstoffpartikel 10 ist nicht notwendig. Wie schon im nicht erfindungsgemäßen Ausführungsbeispiel von Figur 6b muss nur eine Lichtmischung und ein Einstellen der Abstrahlcharakteristik durch die Streupartikel 11 erreicht werden. Die übrigen Komponenten entsprechen denen in Figur 6b.

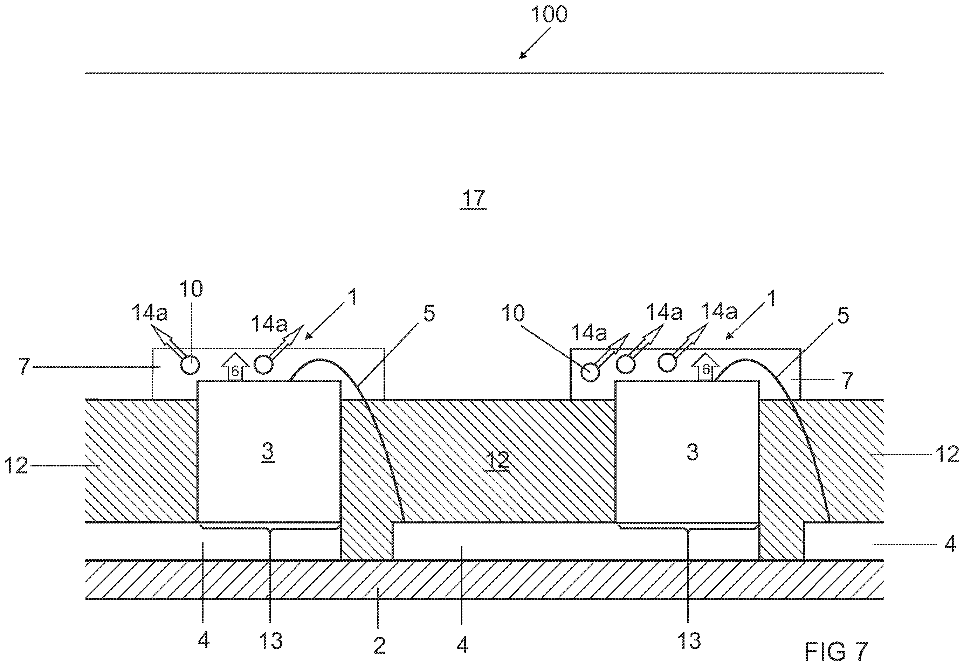

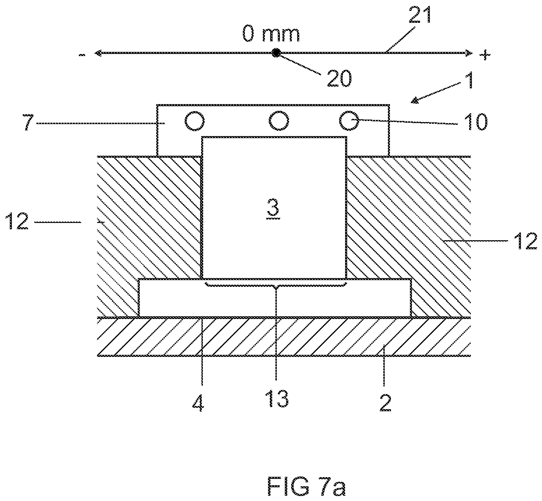

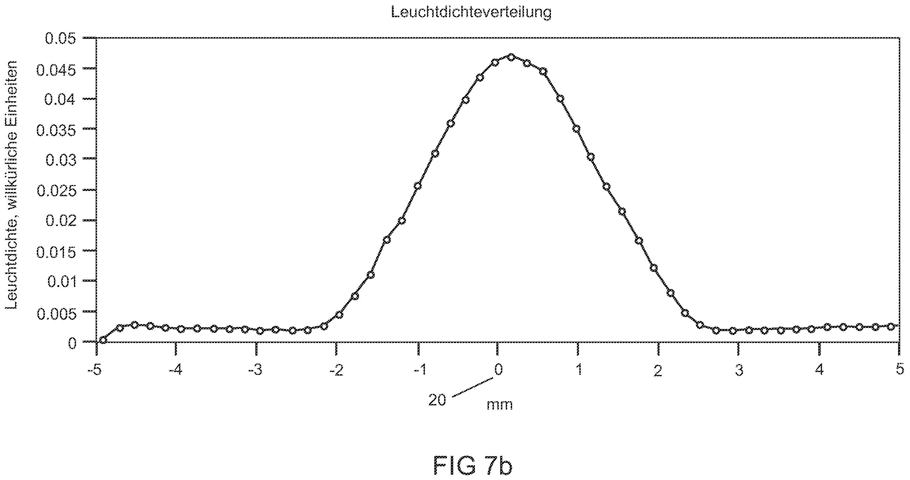

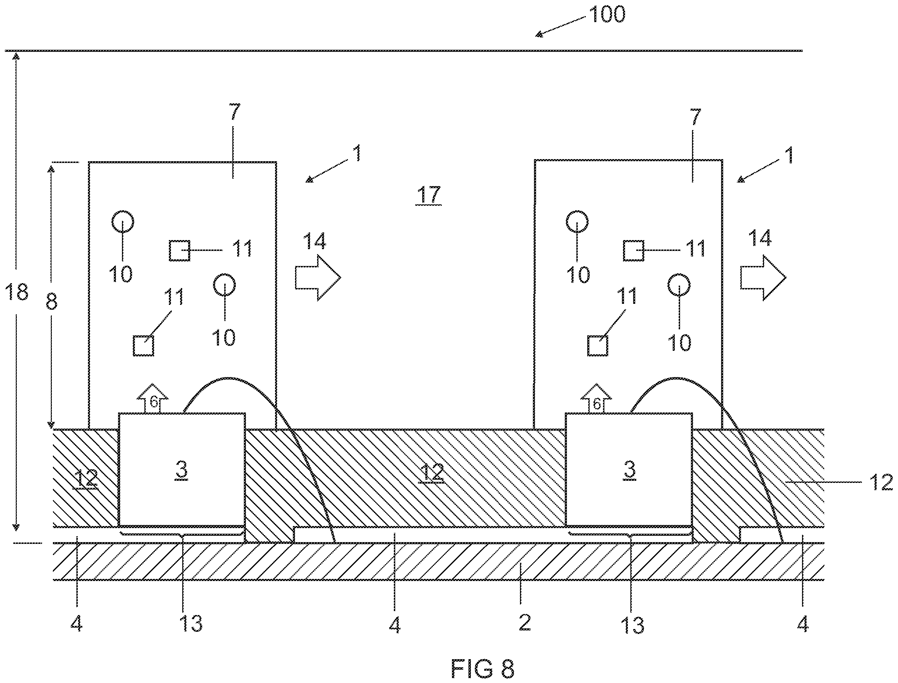

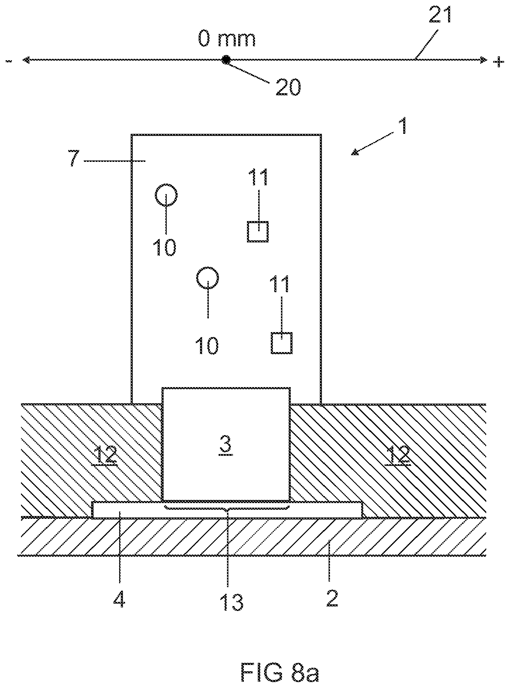

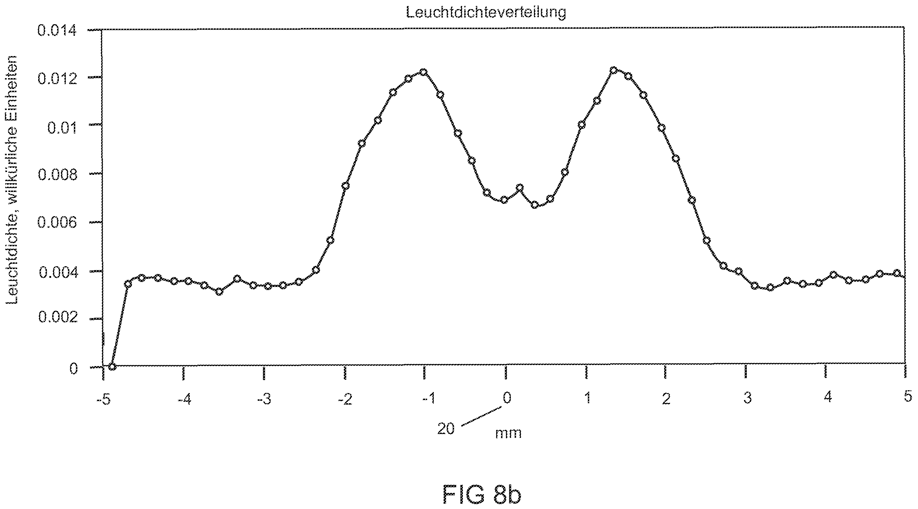

Figur 7 ist als Referenz einer Leuchtvorrichtung zu sehen. Figur 7 stellt weiße LEDs mit chip level conversion dar, die in einem Lichtleiter 17 eingebettet sind. Die weiße LED weist einen Halbleiterchip 3, der eine Primärstrahlung 6 emittiert, und ein auf den Halbleiterchip 3 aufgesetztes dünnes Medium 7 mit einer typischen Dicke von etwa 30 µm auf. Mit anderen Worten beträgt die Höhe 8 des Mediums 7 nur einen Bruchteil der Chipbreite 13 des Halbleiterchips 3. Die Seitenflächen des Mediums 7, die senkrecht auf den Träger 2 stehen, sind klein im Vergleich zur Oberfläche des Mediums 7, die parallel zum Träger 2 angeordnet ist. Das dünne Medium 7 enthält Leuchtstoffpartikel 10 zur Wellenlängenkonversion. Zur Erhöhung der Effizienz ist eine reflektierende Schicht 12 vorgesehen, die die Halbleiterchips 3 umgibt. Die weiße LED hat ein annähernd Lambertsches Emissionsprofil. Bedingt durch die geringe Dicke des Mediums 7 ergibt sich eine größten Teils vorwärtsgerichtete Emission. Dies hat zur Folge, dass nur sehr wenig elektromagnetische Strahlung in den Lichtleiter eingekoppelt wird, während das meiste Licht direkt frontal und punktuell über dem Halbleiterchip 3 abgegeben wird. In einer Reihenanordnung von optoelektronischen Bauelementen in dem Lichtleiter 17 ist eine sehr inhomogene Leuchtdichteverteilung die Folge. Diese Nachteile werden am deutlichsten durch die in den Figuren 8, 11 und 12 gezeigten Ausführungsbeispiele überwunden. Der Nullpunkt 20 für die in Figur 7b dargestellte Leuchtdichteverteilung liegt mittig über dem jeweiligen optoelektronischen Bauelement 1.

Figur 7a zeigt eines der beiden in Figur 7 dargestellten optoelektronischen Bauelemente 1. Beide Bauelemente 1 sind identisch. Deshalb gilt für beide Bauelemente 1 die gleiche Leuchtdichteverteilung. Der Nullpunkt 20 der Leuchtdichteverteilung ist bei 0 mm und liegt zentral und mittig über dem optoelektronischen Bauelement 1. Zur Orientierung ist die horizontale Achse 21 mit der Lage des Nullpunkts 20 angegeben.

Figur 7b zeigt eine Simulation der Leuchtdichteverteilung für das in Figur 7a dargestellte optoelektronische Bauelement 1. Beim Nullpunkt 20 ist die Leuchtdichte maximal und liegt bei über 0,045 (in willkürlichen Einheiten). Zu beiden Seiten (+2 mm bis -2 mm) des Nullpunkts 20 fällt die Leuchtdichte innerhalb von 2 mm auf unter 0,005 (in willkürlichen Einheiten) ab. Es zeigt sich ein Lambertsches Strahlungsprofil. Wie schon in Figur 7 beschrieben eignet sich deshalb das in Figur 7a gezeigte optoelektronische Bauelement kaum für eine seitliche Einkopplung von Licht in einen Lichtleiter 17.

Figur 8 zeigt eine Anordnung 100 aus einem Lichtleiter 17 mit zwei eingebetteten optoelektronischen Bauelementen 1. Der Abstand der Halbleiterchips 3 beträgt etwa 10 mm, die Höhe 18 des Lichtleiter 17 beträgt etwa 2 mm und die Höhe 8 des Mediums 7 beträgt etwa 1,5 mm. Der optimale Abstand zwischen den Halbleiterchips 3 wird nach folgenden Kriterien bestimmt. Durch so viele Halbleiterchips 3 wie nötig wird eine Flächenlichtquelle mit homogener Leuchtdichte und optimaler Entwärmung erzeugt. Aus Kostengründen sollen so wenige Halbleiterchips 3 wie möglich für die benötigte Lichtmenge verwendet werden. Insgesamt ist es sinnvoll, für ein optimales thermisches Management mehr Halbleiterchips 3 mit weniger Einzelleistung zu wählen. Lichterzeugung und Wärmeerzeugung sollen gespreizt werden. Die optoelektronischen Bauelemente entsprechen denen aus Figur 1. Die Einbettung in den Lichtleiter 17 dient der lateralen Verteilung der Sekundärstrahlung 14. Dadurch wird eine homogene Lichtverteilung erreicht. Es ergibt sich ein qualitativ hochwertiger optischer Eindruck, der insbesondere für Hinterleuchtungsanwendungen notwendig ist. In Figur 7, die als Referenz dient, wird nur sehr wenig Sekundärstrahlung 14 lateral in den Lichtleiter 17 eingekoppelt. Die meiste Sekundärstrahlung wird direkt frontal und punktuell abgegeben. Im Ausführungsbeispiel von Figur 8 hingegen erfolgt eine erhöhte seitliche Emission. Dadurch kann die Breite des Leuchtflecks gegenüber der Anordnung in Figur 7 etwa verdoppelt werden. Statt etwa 2 mm werden 4 mm Breite erreicht. Damit ergibt sich die Möglichkeit bei gleicher Lichtleiterdicke die Anzahl der optoelektronischen Bauelemente 1 gegenüber der Referenz auf ein Viertel zu reduzieren. Darüber hinaus wird die Homogenität der Leuchtdichte stark verbessert und der Leuchtdichte-Kontrast zwischen der maximalen Intensität und dem Hintergrund auf einen Faktor 3 reduziert. In dem in Figur 7 dargestellten Referenzbeispiel beträgt dieser Faktor etwa 20.

Figur 8a zeigt eines der beiden in Figur 8 dargestellten optoelektronischen Bauelemente 1. Beide Bauelemente 1 sind identisch. Deshalb gilt für beide Bauelemente 1 die gleiche Leuchtdichteverteilung. Der Nullpunkt 20 der Leuchtdichteverteilung ist bei 0 mm und liegt zentral und mittig über dem optoelektronischen Bauelement 1. Zur Orientierung ist die horizontale Achse 21 mit der Lage des Nullpunkts 20 angegeben.

Figur 8b zeigt die simulierte Leuchtdichteverteilung für das in Figur 8a dargestellte optoelektronische Bauelement 1. Beim Nullpunkt 20 liegt die Leuchtdichte zwischen 0,006 und 0,008. Im Abstand von etwa 1 mm vom Nullpunkt 20 liegt die Leuchtdichte bei etwa 0,012. Die maximale Leuchtdichte wird nicht mehr zentral über dem Halbleiterchip sondern seitlich abgegeben. Im Abstand von etwa 3mm vom Nullpunkt 20 ist die Leuchtdichte auf unter 0,004 abgefallen. Das bevorzugt in seitlicher Richtung abgegebene Licht ist günstig für eine seitliche Einkopplung in einen Wellenleiter 17.

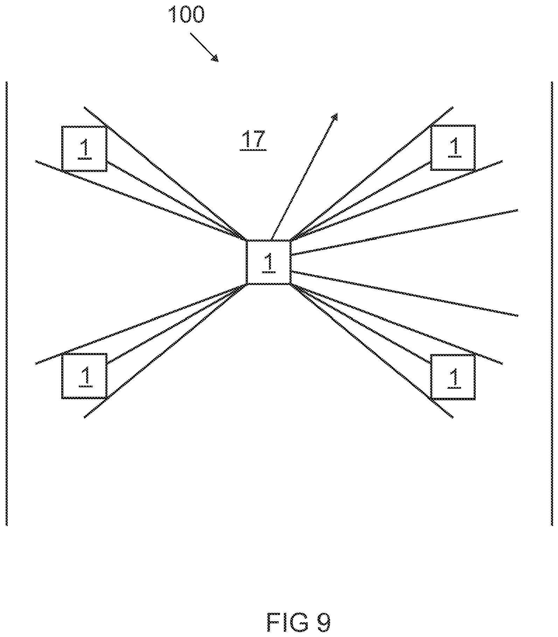

Figur 9 zeigt eine Anordnung 100 aus einem Lichtleiter 17 mit eingebetteten optoelektronischen Bauelementen 1. Dies veranschaulicht, dass es sich bei der Anordnung 100 um eine flächige Ausgestaltung handelt. In dieser Darstellung wird deutlich, dass die gegenseitige Abschattung durch die optoelektronischen Bauelemente 1 vernachlässigbar klein ist.

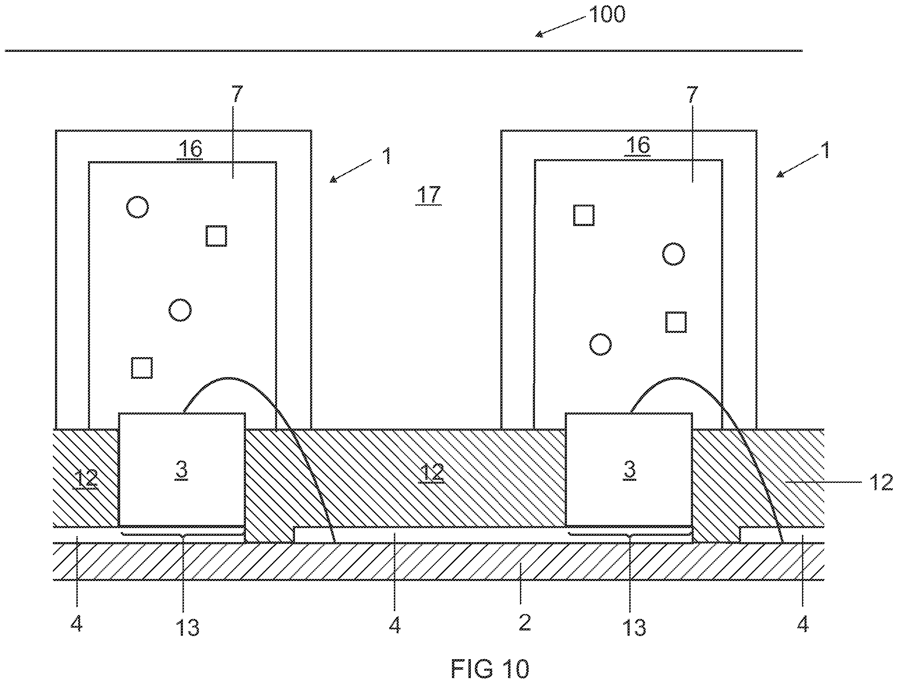

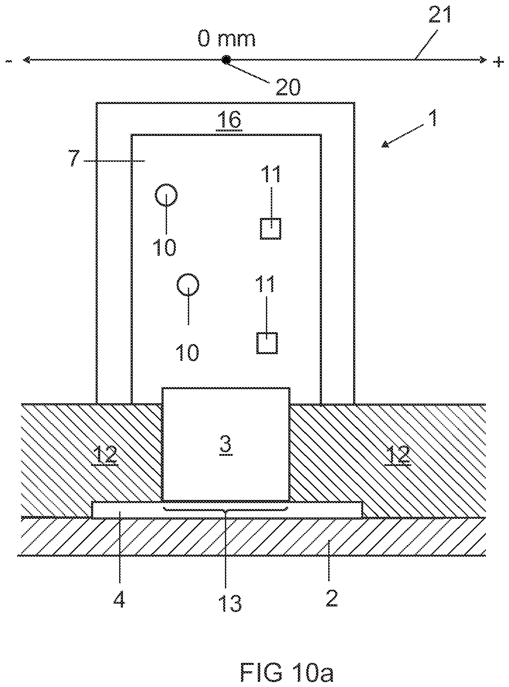

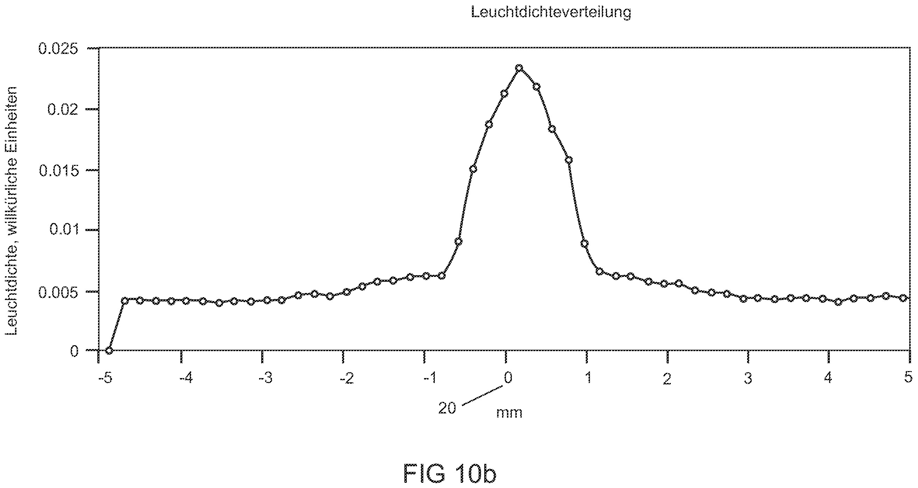

Figur 10 zeigt, wie schon Figur 8, eine Anordnung 100 aus einem Lichtleiter 17 mit eingebetteten optoelektronischen Bauelementen 1. Anders als in Figur 8 ist um das optoelektronische Bauelement 1 ein Luftspalt 16 vorgesehen, der zu einer besseren Einkopplung der Sekundärstrahlung 14 in die geführten Moden des Lichtleiters 17 führt. Die Sekundärstrahlung 14 wird über einen zusätzlichen Streumechanismus im Volumen oder an der Oberfläche des Lichtleiters 17 ausgekoppelt. Damit wird die Homogenität der Leuchtdichte in großen Bereichen verbessert.
Figur 10a zeigt eines der beiden in Figur 10 dargestellten optoelektronischen Bauelemente 1. Beide Bauelemente 1 sind identisch. Deshalb gilt für beide Bauelemente 1 die gleiche Leuchtdichteverteilung. Der Nullpunkt 20 der Leuchtdichteverteilung ist bei 0 mm und liegt zentral und mittig über dem optoelektronischen Bauelement 1. Zur Orientierung ist die horizontale Achse 21 mit der Lage des Nullpunkts 20 angegeben.
Figur 10b zeigt die simulierte Leuchtdichteverteilung für das in Figur 10a dargestellte optoelektronische Bauelemente 1. Beim Nullpunkt 20 liegt die Leuchtdichte zwischen 0,02 und 0,025. Im Abstand von etwa 1 mm vom Nullpunkt 20 ist die Leuchtdichte auf etwa 0,006 abgefallen. Die maximale Leuchtdichte wird zentral über dem Halbleiterchip abgegeben. Im Abstand von etwa 2mm bis etwa 5mm vom Nullpunkt 20 liegt die Leuchtdichte in etwa konstant bei etwa 0,004

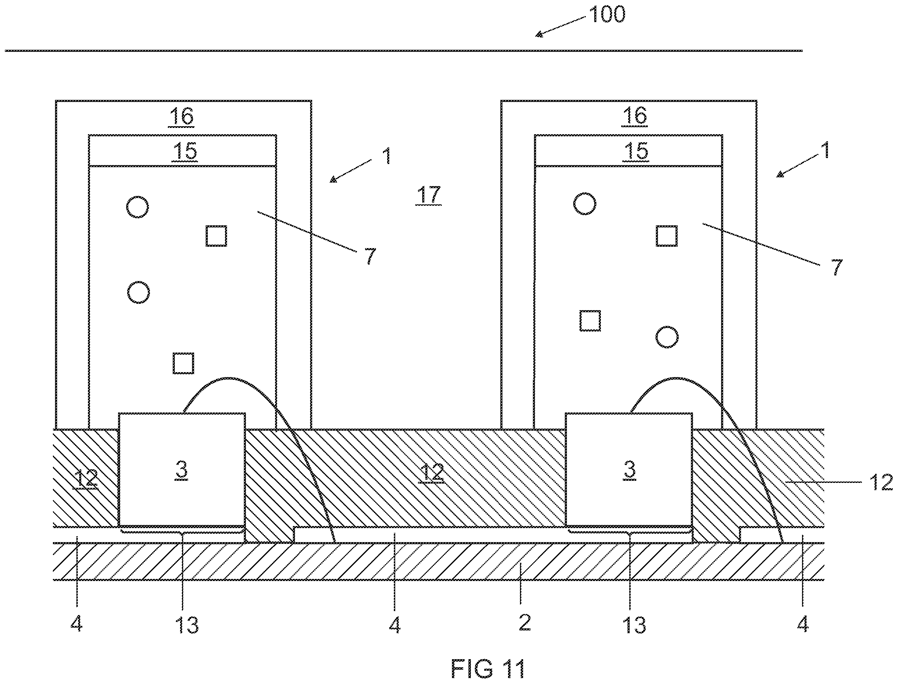

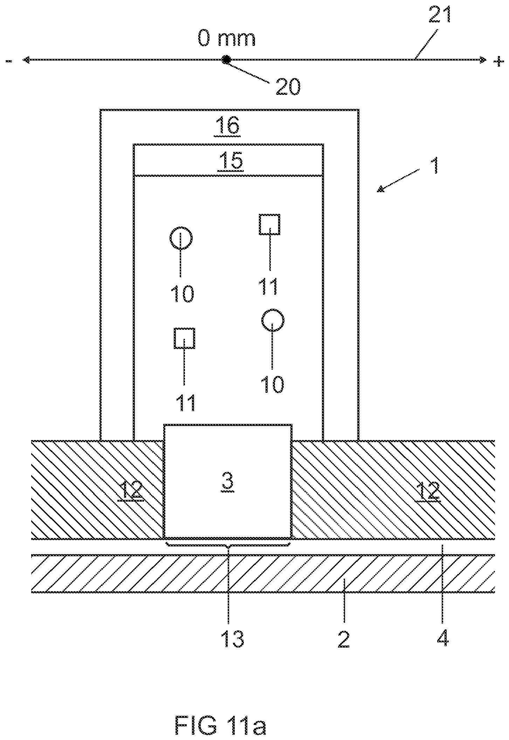

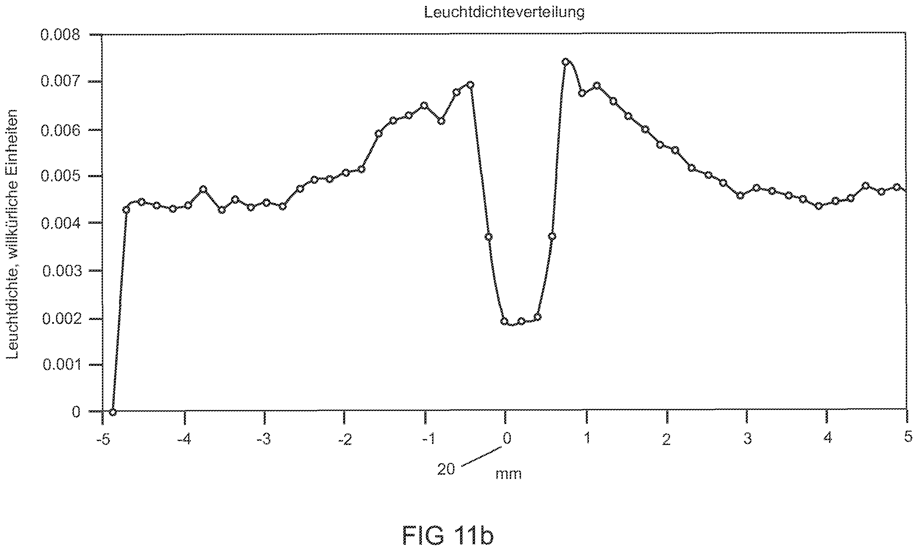

Figur 11 zeigt ein noch vorteilhafteres erfindungsgemäßes, Ausführungsbeispiel als das in Figur 10 dargestellte. Um die punktuelle Emission der Sekundärstrahlung 14 zu verhindern, wird zusätzlich an der dem Halbleiterchip 3 abgewandten Seite des Mediums 7 eine semitransparente oder teilreflektierende Schicht 15 angeordnet. Dies führt zu einer Homogenisierung der Sekundärstrahlung 14. Der Luftspalt 16 liegt zwischen Medium 7 mit teilreflektierender Schicht 15 und dem Wellenleiter 17.
Figur 11a zeigt eines der beiden in Figur 11 dargestellten optoelektronischen Bauelemente 1. Beide Bauelemente 1 sind identisch. Deshalb gilt für beide Bauelemente 1 die gleiche Leuchtdichteverteilung. Der Nullpunkt 20 der Leuchtdichteverteilung ist bei 0 mm und liegt zentral und mittig über dem optoelektronischen Bauelement 1. Zur Orientierung ist die horizontale Achse 21 mit der Lage des Nullpunkts 20 angegeben.

Figur 11b zeigt die simulierte Leuchtdichteverteilung für das in Figur 11a dargestellte optoelektronische Bauelemente 1 für den Fall einer teiltransparenten Schicht 15 mit etwa 95% Reflexion. Beim Nullpunkt 20 liegt die Leuchtdichte bei etwa 0,002. Im Abstand von etwa 1 mm vom Nullpunkt 20 ist die Leuchtdichte auf etwa 0,007 angewachsen. Im Abstand von 1 mm bis 5 mm vom Nullpunkt 20 fällt die Leuchtdichte auf etwa 0,0045 langsam ab. Die maximale Leuchtdichte wird also nicht in zentraler Richtung über dem Nullpunkt 20 sondern seitlich vom Nullpunkt 20 erreicht. Für eine seitliche Einkopplung der elektromagnetischen Strahlung in einen Wellenleiter 17 ist das Bauelement aus Figur 11a deshalb gut geeignet. Durch geeignete Wahl des Reflexionsgrades der teiltransparenten Schicht 15 lässt sich die Homogenität der Leuchtdichte weiter optimieren.

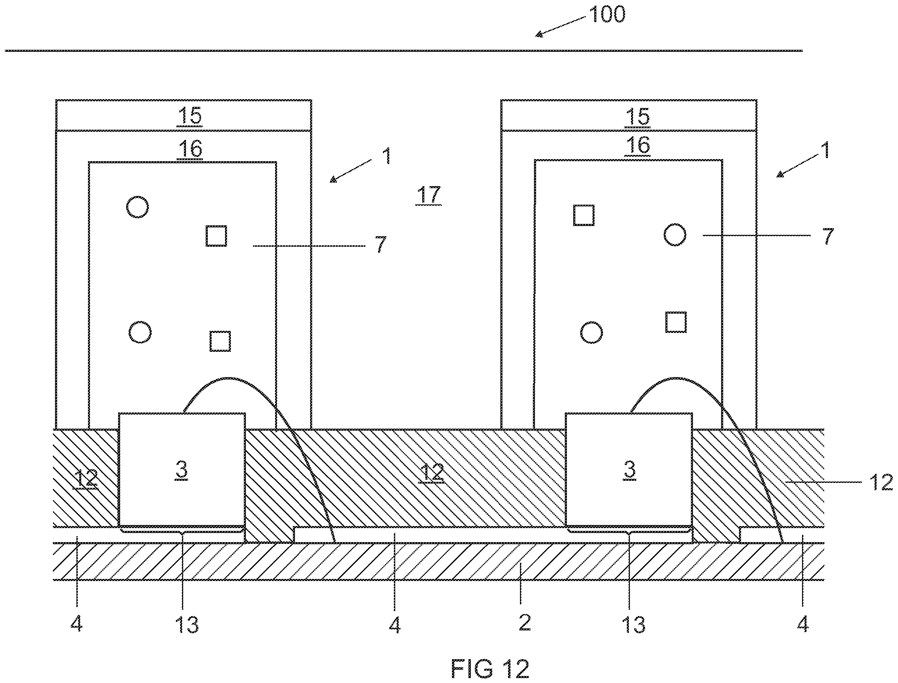

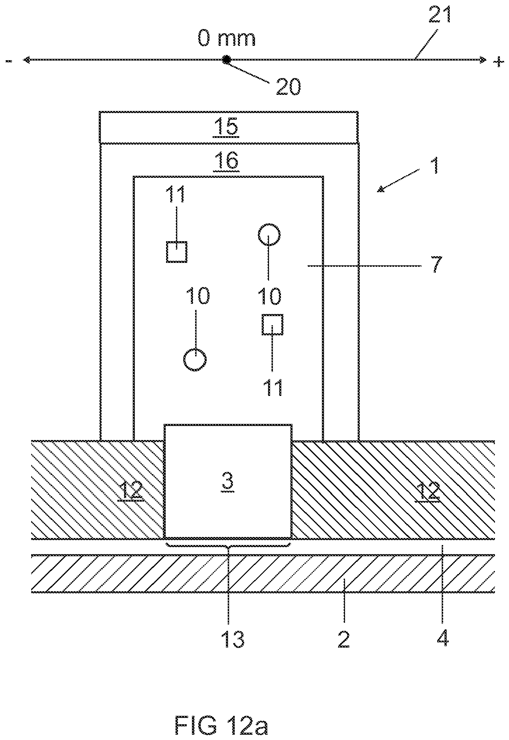

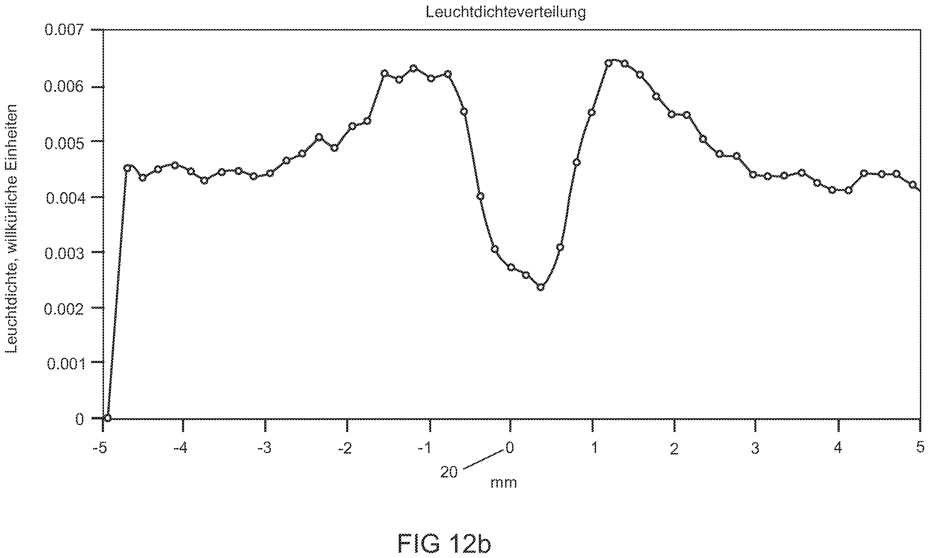

Alternativ zum erfindungsgemäßen Ausführungsbeispiel in Figur 11 kann die teilreflektierende Schicht 15 an der Innenseite der Aussparungen im Lichtleiter 17 angebracht werden. Dies ist in Figur 12 gezeigt. Gegenüber dem erfindungsgemäßen Ausführungsbeispiel aus Figur 11 kann durch das erfindungsgemäße Ausführungsbeispiel aus Figur 12 die Homogenität der Leuchtdichte weiter optimiert werden. Der Luftspalt 16 liegt zwischen Medium 7 und Wellenleiter 17 mit daran befestigter teilreflektierender Schicht 15.
Figur 12a zeigt eines der beiden in Figur 12 dargestellten optoelektronischen Bauelemente 1. Beide Bauelemente 1 sind identisch. Deshalb gilt für beide Bauelemente 1 die gleiche Leuchtdichteverteilung. Der Nullpunkt 20 der Leuchtdichteverteilung ist bei 0 mm und liegt zentral und mittig über dem optoelektronischen Bauelement 1. Zur Orientierung ist die horizontale Achse 21 mit der Lage des Nullpunkts 20 angegeben.
Figur 12b zeigt die simulierte Leuchtdichteverteilung für das in Figur 12a dargestellte optoelektronische Bauelemente 1 für den Fall einer teiltransparenten Schicht 15 mit etwa 60% Reflexion. Beim Nullpunkt 20 liegt die Leuchtdichte bei etwa 0,0055. Im Abstand von etwa 1 mm vom Nullpunkt 20 ist die Leuchtdichte leicht angewachsen auf etwa 0,006. Im Abstand von 1,5 mm bis 5 mm vom Nullpunkt 20 fällt die Leuchtdichte auf etwa 0,0045 langsam ab. Die maximale Leuchtdichte wird also nicht in zentraler Richtung über dem Nullpunkt 20 sondern seitlich vom Nullpunkt 20 erreicht. Näherungsweise ist die Leuchtdichte jedoch homogen verteilt in einem Bereich von 5 mm zu beiden Seiten des Nullpunkts 20. Für eine seitliche Einkopplung der elektromagnetischen Strahlung in einen Wellenleiter 17 ist das Bauelement aus Figur 12a deshalb besonders gut geeignet. Wie gezeigt lässt sich durch geeignete Wahl des Reflexionsgrades der teiltransparenten Schicht 15, die Homogenität der Leuchtdichte optimieren.

Das optoelektronische Bauelement wurde zur Veranschaulichung des zugrundeliegenden Gedankens anhand einiger Ausführungsbeispiele beschrieben. Die Ausführungsbeispiele sind dabei nicht auf bestimmte Merkmalskombinationen beschränkt. Auch wenn einige Merkmale und Ausgestaltungen nur im Zusammenhang mit einem besonderen Ausführungsbeispiel oder einzelnen Ausführungsbeispielen beschrieben wurden, können sie jeweils mit anderen Merkmalen aus anderen Ausführungsbeispielen kombiniert werden. Es ist ebenso denkbar, in Ausführungsbeispielen einzelne dargestellte Merkmale oder besondere Ausgestaltungen wegzulassen oder hinzuzufügen, soweit die allgemeine technische Lehre realisiert bleibt.

### Bezugszeichenliste

- 1: optolektronisches Bauelement
- 2: Träger
- 3: Halbleiterchip
- 4: Kontakte
- 5: Bonddraht
- 6: Primärstrahlung
- 6a: erster Anteil der Primärstrahlung
- 6b: zweiter Anteil der Primärstrahlung
- 7: Medium
- 8: Höhe des Mediums
- 9: Breite des Mediums
- 10: Leuchtstoffpartikel
- 11: Streupartikel
- 12: reflektierende Schicht
- 13: Chipbreite
- 14: Sekundärstrahlung
- 14a: erster Anteil der Sekundärstrahlung
- 14b: zweiter Anteil der Sekundärstrahlung
- 15: teilreflektierende Schicht
- 16: Luftspalt
- 17: Lichtleiter
- 18: Lichtleiterhöhe
- 20: Nullpunkt
- 21: Horizontale Achse der Simulationen, Einheit: mm
- 100: Anordnung aus Lichtleiter mit eingebetteten optoelektronischen Bauelementen

## Patentansprüche

1. Optoelektronisches Bauelement (1) mit:
- einem Träger (2),
- mindestens einem Halbleiterchip (3), angeordnet auf dem Träger (2), zum Emittieren einer Primärstrahlung (6),
- einem den Halbleiterchip (3) zumindest teilweise umschließenden und zumindest teilweise transparenten Medium (7) mit einer Höhe (8) über dem Träger (2) und einer Breite (9) entlang des Trägers (2) und
- in dem Medium (7) eingebrachten Partikeln (10, 11) zur Wechselwirkung mit der Primärstrahlung (6), wobei die Partikel (10, 11) Leuchtstoffpartikel (10) aufweisen, die für eine Absorption der Primärstrahlung (6) und eine Emission eines ersten Anteils (14a) einer Sekundärstrahlung (14) ausgelegt sind, und Streupartikel (11) aufweisen, die für die Streuung der Primärstrahlung (6) ausgelegt sind und dabei einen zweiten Anteil (14b) zur Sekundärstrahlung (14) beitragen,
wobei das Medium (7) ein Verhältnis der Höhe (8) zu der Breite (9) von größer als 1 aufweist,
wobei eine teilreflektierende Schicht (15) zumindest bereichsweise an einer vom Halbleiterchip (3) abgewandten Seite des Mediums (7) vorgesehen ist, und wobei die Partikel (10, 11) homogen in dem Medium (7) verteilt sind.

2. Optoelektronisches Bauelement gemäß Anspruch 1, wobei die Leuchtstoffpartikel (10), insbesondere aus einem phosphoreszenten Material, insbesondere aus Lanthan dotiertem Yttriumoxid (Y₂O₃-La₂O₃), Yttrium Aluminium Granat (Y₃Al₅O₁₂), Dysprosiumoxid (Dy₂O₃) , Aluminium Oxynitrid (Al₂₃O₂₇N₅) oder Aluminium Nitrid (AlN) in einer Konzentration von 5 bis 15 Gewichtsprozent vorliegen.

3. Optoelektronisches Bauelement gemäß Anspruch 1 oder 2, wobei die Streupartikel (11), insbesondere Bariumsulfid, Bariumsulfit, Bariumsulfat oder Titandioxid, in einer Konzentration von 2 bis 10 Gewichtsprozent aufweisen.

4. Optoelektronisches Bauelement gemäß einem der vorigen Ansprüche, wobei die Höhe (8) des Mediums (7) zwischen dem etwa 1-Fachen und etwa 3-Fachen einer Chipbreite (13) des Halbleiterchips (3) entlang des Trägers (2) beträgt.

5. Optoelektronisches Bauelement gemäß einem der vorigen Ansprüche, wobei eine reflektierende Schicht (12) zumindest bereichsweise an einer dem Halbleiterchip (3) zugewandten Seite des Mediums (7) vorgesehen ist.

6. Optoelektronisches Bauelement gemäß Anspruch 5, wobei die reflektierende Schicht (12) ein Titandioxid-Partikel umfassendes Silikon aufweist.

7. Optoelektronisches Bauelement gemäß einem der vorigen Ansprüche, wobei die teilreflektierende Schicht (15) an der vom Halbleiterchip (3) abgewandten Seite des Mediums (7) in unmittelbarem Kontakt mit dem Medium (7) angeordnet ist.

8. Optoelektronisches Bauelement gemäß einem der Ansprüche 1 bis 6, wobei zwischen der teilreflektierenden Schicht (15) an der vom Halbleiterchip (3) abgewandten Seite des Mediums (7) und dem Medium (7) ein Luftspalt (16) vorgesehen ist.

9. Optoelektronisches Bauelement gemäß einem der vorigen Ansprüche, wobei die teilreflektierende Schicht (15) ein Titandioxid-Partikel umfassendes Silikon aufweist.

10. Leuchtvorrichtung (100) mit mindestens einem optoelektronischen Bauelement (1) gemäß einem der vorigen Ansprüche, wobei das optoelektronische Bauelement (1) an einen Lichtleiter (17) optisch gekoppelt ist.

11. Leuchtvorrichtung gemäß Anspruch 10, wobei zwischen dem optoelektronischen Bauelement (1) und dem Lichtleiter (17) ein Luftspalt (16) vorgesehen ist.

12. Verfahren zur Herstellung eines optoelektronischen Bauelement (1) mit folgenden Verfahrensschritten:
- Bereitstellen eines Halbleiterchips (3) auf einem Träger (2) ;
- Einbringen von Partikeln (10, 11) in ein Medium (7) aus einem transparentem Matrixmaterial, insbesondere einem transparentem Silikon, wobei die Partikel (10, 11) Leuchtstoffpartikel (10) aufweisen, die für eine Absorption einer Primärstrahlung (6) des Halbleiterchips (3) und eine Emission eines ersten Anteils (14a) einer Sekundärstrahlung (14) ausgelegt sind, und Streupartikel (11) aufweisen, die für die Streuung der Primärstrahlung (6) ausgelegt sind und dabei einen zweiten Anteil (14b) zur Sekundärstrahlung (14) beitragen;
- Gießen des Mediums (7) in eine Form;
- thermisches Aushärten des Mediums (7);
- Aufbringen des Mediums (7) auf den Halbleiterchip (3), so dass ein Verhältnis einer Höhe (8) des Mediums (7) über dem Träger (2) zu einer Breite (9) des Mediums (7) entlang des Trägers (2) größer als 1 ist; und
- Aufbringen einer teilreflektierenden Schicht (15) zumindest bereichsweise an einer vom Halbleiterchip (3) abgewandten Seite des Mediums (7);
wobei die Partikel (10, 11) homogen in dem Medium (7) verteilt sind.

## Claims

1. An optoelectronic component (1) comprising:
- a carrier (2),
- at least one semiconductor chip (3), arranged on the carrier (2), for emitting a primary radiation (6),
- an at least partly transparent medium (7) at least partly enclosing the semiconductor chip (3) and having a height (8) above the carrier (2) and a width (9) along the carrier (2), and
- particles (10, 11) introduced in the medium (7) and serving for interaction with the primary radiation (6),
wherein the particles (10, 11) comprise phosphor particles (10) designed for an absorption of the primary radiation (6) and an emission of a first portion (14a) of a secondary radiation (14), and comprise scattering particles (11) which are designed for the scattering of the primary radiation (6) and thereby contribute a second portion (14b) to the secondary radiation (14),
wherein the medium (7) has a ratio of the height (8) to the width (9) of greater than 1,
wherein a partly reflective layer (15) is provided at least in regions on a side of the medium (7) which faces away from the semiconductor chip (3), and wherein the particles (10, 11) are distributed homogeneously in the medium (7).

2. The optoelectronic component as claimed in claim 1,
wherein the phosphor particles (10), in particular composed of a phosphorescent material, in particular composed of lanthanum-doped yttrium oxide (Y₂O₃-La₂O₃), yttrium aluminum garnet (Y₃Al₅O₁₂), dysprosium oxide (Dy₂O₃), aluminum oxynitride (Al₂₃O₂₇N₅) or aluminum nitride (AlN) are present in a concentration of 5 to 15 percent by weight.

3. The optoelectronic component as claimed in claim 1 or 2,
wherein the scattering particles (11), in particular barium sulfide, barium sulfite, barium sulfate or titanium dioxide, have a concentration of 2 to 10 percent by weight.

4. The optoelectronic component as claimed in any of the preceding claims, wherein the height (8) of the medium (7) is between 1 times and 3 times a chip width (13) of the semiconductor chip (3) along the carrier (2).

5. The optoelectronic component as claimed in any of the preceding claims, wherein a reflective layer (12) is provided at least in regions on a side of the medium (7) which faces the semiconductor chip (3).

6. The optoelectronic component as claimed in claim 5,
wherein the reflective layer (12) comprises a silicon comprising titanium dioxide particles.

7. The optoelectronic component as claimed in any of the preceding claims, wherein the partly reflective layer (15) is arranged on the side of the medium (7) which faces away from the semiconductor chip (3) in direct contact with the medium (7).

8. The optoelectronic component as claimed in any of claims 1 to 6, wherein an air gap (16) is provided between the partly reflective layer (15) on the side of the medium (7) which faces away from the semiconductor chip (3) and the medium (7).

9. The optoelectronic component as claimed in any of the preceding claims, wherein the partly reflective layer (15) comprises a silicon comprising titanium dioxide particles.

10. A lighting device (100) comprising at least one optoelectronic component (1) as claimed in any of the preceding claims, wherein the optoelectronic component (1) is optically coupled to an optical waveguide (17).

11. The lighting device as claimed in claim 10, wherein an air gap (16) is provided between the optoelectronic component (1) and the optical waveguide (17).

12. A method for producing an optoelectronic component (1) comprising the following method steps:
- providing a semiconductor chip (3) on a carrier (2);
- introducing particles (10, 11) into a medium (7) composed of a transparent matrix material, in particular a transparent silicon, wherein the particles (10, 11) comprise phosphor particles (10) designed for an absorption of the primary radiation (6) and an emission of a first portion (14a) of a secondary radiation (14), and comprise scattering particles (11) which are designed for the scattering of the primary radiation (6) and in this case contribute a second portion (14b) to the secondary radiation (14);
- pouring the medium (7) into a mold;
- thermally curing the medium (7);
- applying the medium (7) to the semiconductor chip (3), such that a ratio of a height (8) of the medium (7) above the carrier (2) to a width (9) of the medium (7) along the carrier (2) is greater than 1; and
- applying a partly reflective layer (15) at least in regions on a side of the medium (7) which faces away from the semiconductor chip (3),
wherein the particles (10, 11) are distributed homogeneously in the medium (7).

## Revendications

1. Composant optoélectronique (1) comprenant :
- un support (2),
- au moins une puce à semi-conducteur (3) disposée sur le support (2), destinée à émettre un rayonnement primaire (6),
- un milieu (7) entourant la puce à semi-conducteur (3) au moins en partie et transparent au moins en partie, avec une hauteur (8) au-dessus du support (2) et d'une largeur (9) le long du support (2), et
- des particules (10, 11) introduites dans le milieu (7) pour l'interaction avec le rayonnement primaire (6), les particules (10, 11) présentant des particules de substance luminescente(10) qui sont conçues pour une absorption du rayonnement primaire (6) et pour une émission d'une première fraction (14a) d'un rayonnement secondaire (14), et des particules de dispersion (11) qui sont conçues pour la dispersion du rayonnement primaire (6) et apportent une seconde fraction (14b) au rayonnement secondaire (14),
le milieu (7) présentant un rapport hauteur (8) - largeur (9) supérieur à 1,
une couche (15) partiellement réfléchissante étant ménagée au moins par zones sur un côté du milieu (7), détourné de la puce à semi-conducteur (3), et les particules (10, 11) étant réparties de manière homogène dans le milieu (7).

2. Composant optoélectronique selon la revendication 1, les particules de substance luminescente (10), notamment provenant d'un matériau phosphorescent, notamment d'oxyde d'yttrium dopé au lanthane (Y₂O₃-La₂O₃), de grenat d'yttrium et d'aluminium (Y₃Al₅O₁₂), d'oxyde de dysprosium (Dy₂O₃), d'oxynitrure d'aluminium (Al₂₃O₂₇N₅) ou de nitrure d'aluminium (AlN), étant présentes dans une concentration de 5 à 15 pour cent en poids.

3. Composant optoélectronique selon la revendication 1 ou 2, les particules de dispersion (11) présentant notamment du sulfure de baryum, du sulfite de baryum, du sulfate de baryum ou du dioxyde de titane dans une concentration de 2 à 10 pour cent en poids.

4. Composant optoélectronique selon l'une quelconque des revendications précédentes, la hauteur (8) du milieu (7) étant comprise entre environ 1 fois à environ 3 fois une largeur de puce (13) de la puce à semi-conducteur (3) le long du support (2).

5. Composant optoélectronique selon l'une quelconque des revendications précédentes, une couche réfléchissante (12) étant ménagée au moins par zones sur un côté du milieu (7), tourné vers la puce à semi-conducteur (3).

6. Composant optoélectronique selon la revendication 5, la couche réfléchissante (12) présentant une silicone comprenant des particules de dioxyde de titane.

7. Composant optoélectronique selon l'une quelconque des revendications précédentes, la couche (15) partiellement réfléchissante étant disposée en contact direct avec le milieu (7) sur le côté du milieu (7), détourné de la puce à semi-conducteur (3).

8. Composant optoélectronique selon l'une quelconque des revendications 1 à 6, un espace d'air (16) étant prévu entre la couche (15) partiellement réfléchissante, sur le côté du milieu (7), détourné de la puce à semi-conducteur (3), et le milieu (7).

9. Composant optoélectronique selon l'une quelconque des revendications précédentes, la couche (15) partiellement réfléchissante présentant une silicone comprenant des particules de dioxyde de titane.

10. Dispositif d'éclairage (100) comprenant au moins un composant optoélectronique (1) selon l'une quelconque des revendications précédentes, le composant optoélectronique (1) étant couplé optiquement à un conducteur optique (17) .

11. Dispositif d'éclairage selon la revendication 10, un espace d'air (16) étant prévu entre le composant optoélectronique (1) et la fibre optique (17).

12. Procédé de fabrication d'un composant optoélectronique (1), comprenant les étapes de procédé suivantes :
- fourniture d'une puce à semi-conducteur (3) sur un support (2) ;
- introduction de particules (10,11) dans un milieu (7) constitué d'un matériau matriciel transparent, notamment d'une silicone transparente, les particules (10, 11) présentant des particules de substance luminescente (10) qui sont conçues pour une absorption d'un rayonnement primaire (6) et pour une émission d'une première fraction (14a) d'un rayonnement secondaire (14), et des particules de dispersion (11) qui sont conçues pour la dispersion du rayonnement primaire (6) et apportent une seconde fraction (14b) au rayonnement secondaire (14) ;
- coulage du milieu (7) dans un moule ;
- durcissement thermique du milieu (7) ;
- application du milieu (7) sur la puce à semi-conducteur (3) de manière à ce qu'un rapport d'une hauteur (7) du milieu (7) au-dessus du support (2) par rapport à une largeur (9) du milieu (7) le long du support (2) soit supérieur à 1 ; et
- application d'une couche (15) partiellement réfléchissante au moins par zones sur un côté du milieu (7), détourné de la puce à semi-conducteur (3) ;
les particules (10, 11) étant réparties de manière homogène dans le milieu (7).
